Europäisches Patentamt

European Patent Office

Office européen des brevets

(19)

(11) Veröffentlichungsnummer: **0 359 966**
**A2**

(12) **EUROPÄISCHE PATENTANMELDUNG**

(21) Anmeldenummer: 89114583.1

(22) Anmeldetag: 07.08.89

(51) Int. Cl.5: **H01J 37/32 , H05H 1/46**

(30) Priorität: 23.09.88 DE 3832447

(43) Veröffentlichungstag der Anmeldung:
28.03.90 Patentblatt 90/13

(84) Benannte Vertragsstaaten:
**DE FR GB NL**

(71) Anmelder: **Siemens Aktiengesellschaft**
**Wittelsbacherplatz 2**
**D-8000 München 2(DE)**

(72) Erfinder: **Hübner, Holger, Dr.**
**Hamsterweg 10**
**D-8011 Baldham(DE)**

(54) **Vorrichtung zum reaktiven Ionenätzen.**

(57) Es wird eine Vorrichtung zum reaktiven Ionenätzen angegeben, die den Vorteil hoher Ionendichte
und kleiner Ionenenergie hat, und bei sich Ionendichte und Ionenenergie unabhängig voneinander einstellen lassen.

Die Vorrichtung weist eine Einrichtung (M) zum
Erzeugen eines Magnetfeldes (MF) an der Elektrode
(E1), an welche eine Hochfrequenzspannung (U$_H$)
anzulegen ist, und einen Generator (G) zur Erzeugung einer rechteckwellenförmigen, niederfrequenten Spannung (U) auf, die kapazitiv an eine ein zu
ätzendes Substrat (Sb) tragende andere Elektrode
(E2) anzukoppeln ist. Die niederfrequente Spannung
(U) weist eine negative Halbwelle kurzer Dauer und
eine positive Halbwelle auf. Die Dauer der negativen
Halbwelle ist kürzer als eine Zeitkonstante für Aufladung des Substrats (Sb) nach einem der Amplitude
der Halbwelle entsprechenden Potentialsprung gewählt, und die positive Halbwelle ist so bemessen,
daß das Substrat (Sb) im Mittel ladungsfrei bleibt.

Anwendung für Anlagen zum reaktiven Ionenätzen.

FIG 1

## Vorrichtung zum reaktiven Ionenätzen

Die Erfindung betrifft eine Vorrichtung zum reaktiven Ionenätzen nach dem Oberbegriff des Patentanspruchs 1.

Bei Vorrichtungen der genannten Art wird an die andere Elektrode, auf der das zu ätzende Substrat anzuordnen ist, durch kapazitive Kopplung eine niederfrequente Spannung in Form einer Sinusspannung mit einer negativen Halbwelle angelegt, die als Saugspannung für Ionen wirkt. Dies deshalb, weil beim Anlegen einer Saugspannung in Form einer negativen Gleichspannung an diese Elektrode sich das im allgemeinen isolierende Substrat gemäß einer Exponentialfunktion durch den Ionenbeschuß elektrisch auflädt. Dabei reduziert sich die Ionenenergie und die Ätzung kommt zum Erliegen.

Durch Anlegen der niederfrequenten sinusförmigen Spannung mit der negativen Halbwelle an diese Elektrode wird die durch Ionenbeschuß bewirkte elektrische Aufladung des Substrats durch Elektronenbeschuß während der positiven Halbwelle dieser Spannung vermieden. Es bildet sich ein mittleres Gleichgewichtspotential am Substrat aus, dem allerdings die niederfrequente Spannung überlagert bleibt. Damit ist die Ionenenergie nicht konstant.

Aufgabe der Erfindung ist es, eine Vorrichtung der eingangs genannten Art anzugeben, mit der eine hohe Ionenenergie erzielt und/oder erreicht werden kann, daß das Substrat im Mittel ladungsfrei bleibt.

Diese Aufgabe wird durch die im kennzeichnenden Teil des Patentanspruchs 1 angegebenen Merkmale gelöst.

Besonders vorteilhaft ist es, wenn der Generator der erfindungsgemäßen Vorrichtung gemäß Anspruch 2 eine zumindest im wesentlichen rechteckwellenförmige Spannung erzeugt. Während der Dauer der im wesentlichen rechteckförmigen negativen Halbwelle ist die Saugspannung für die Ionen im wesentlichen konstant. Dies hat ein günstiges schmalbandiges Ionenenergiespektrum zur Folge.

Wenn die negative Halbwelle und die positive Halbwelle hinsichtlich Dauer und Amplitude so gewählt sind, daß die Stromdichten von das Substrat beschießenden Ionen und Elektronen unterschiedlich sind und sich das Substrat auf ein gegenüber Masse negatives Potential $U_o$ auflädt, ist die Ionenenergie $E_i$ durch $E_i = e (U_o + U_{NF})$ gegeben, wobei $U_{NF}$ die Gesamtamplitude der niederfrequenten Spannung und e den Betrag der elektrischen Ladung eines Elektrons bedeuten.

Soll die Ionenenergie direkt durch die Amplitude der negativen Halbwelle der niederfrequenten Spannung eingestellt werden, muß die Amplitude der positiven Halbwelle so bemessen werden, daß das Substrat im zeitlichen Mittel ladungsfrei bleibt, d.h. daß $U_o = 0$ Volt gilt.

Das Einstellen des Substratpotentials auf dieses oder auch ein anderes Potential kann mit den im Anspruch 3 angegebenen Maßnahmen durchgeführt werden, wobei das Substratpotential vorzugsweise gemäß Anspruch 4 auf Massepotential geregelt wird, das 0 Volt entspricht.

Vorteilhaft ist es insbesondere in Verbindung mit dem Merkmal des Anspruchs 4, wenn gemäß Anspruch 5 die Amplitude der negativen Halbwelle steuerbar und dadurch die Ionenenergie variierbar ist.

Wie schon erwähnt, wird bei Vorrichtungen zum reaktiven Ionenätzen mit zwei im Abstand zueinander angeordneten Elektroden zwischen den Elektroden durch Anlegen einer Hochfrequenzspannung an eine Elektrode ein Hochfrequenzplasma erzeugt. Dieses Plasma hat zwei Aufgaben:

a) es dissoziiert und ionisiert das Prozeßgas und

b) im Potentialgefälle zwischen dem Plasma und dem zu prozessierenden Substrat auf der anderen Elektrode werden die Ionen beschleunigt und bewirken ein "anisotropes" Ätzprofil, bei dem die Kanten senkrecht sind und kein Unterätzen auftritt (siehe dazu J. W. Coburn: "Plasmaetching and reactive ion etching", AVS Monograph Series (1982), beispielsweise S. 2 und 4).

Im Interesse eines schnellen und materialschonenden Ätzens soll die Ionendichte hoch und die Ionenenergie klein sein. Bei einer Vorrichtung nach dem Oberbegriff des Patentanspruchs 6 kann eine hohe Ionendichte durch die im kennzeichnenden Teil dieses Patentanspruchs angegebenen Merkmale erhalten werden.

Durch diese Merkmale wird erreicht, daß die Elektronen und damit das Plasma nahe bei der einen Elektrode konzentriert bleiben. Um die Feldlinien des Magnetfeldes herum spiralen sich die Elektronenbahnen und machen daher auch nur in diesem Bereich Ionisation. Damit erhöht sich die Ionendichte und der Beschuß des Substrats mit Elektronen wird verringert.

Bei Vorrichtungen nach dem Oberbegriff des Patentanspruchs 1 sind Ionendichte und Ionenenergie nicht unabhängig voneinander einstellbar, da beide von der Hochfrequenzenergie abhängen.

Um zu einer quasi-unabhängigen Einstellung dieser beiden Parameter zu gelangen, wurde die sog. Triodenkonfiguration vorgeschlagen. Diese Konfiguren unterscheidet sich von der Vorrichtung nach dem Oberbegriff des Patentanspruchs 1 dadurch, daß zwischen den beiden Elektroden ein Gitter angeordnet ist. Zwischen dem Gitter und der einen Elektrode, an welche die Hochfrequenzspannung anzulegen ist, wird das Hochfrequenzplasma unterhalten und damit die Ionendichte eingestellt. Eine zwischen dem Gitter und der das Substrat tragenden anderen Elektrode angelegte niederfrequente Wechselspannung beschleunigt die Ionen auf das Substrat und sorgt für die Ionenenergie.

Bei der Triodenkonfiguration können die Ionen und Elektronen am Gitter rekombinieren und dadurch die Ionendichten wieder reduzieren. Bei der Anregung mit der niederfrequenten Wechselspannung erhalten die Ionen ein breites Spektrum an Energie. Ein optimales Ätzprofil bildet sich jedoch nur bei einer Energie aus.

Durch Kombination einer Vorrichtung nach einem der Ansprüche 1 bis 5, insbesondere nach Anspruch 2 und 5 mit einer Vorrichtung nach Anspruch 6 oder 7, kann vorteilhafterweise eine unabhängige Einstellung von Ionendichte und Ionenenergie erreicht werden, die außerdem gleichzeitig den Vorteil hoher Ionendichte hat, daß die Ionen ein schmales Spektrum an Energien erhalten, das auf die Energie eingestellt werden kann, bei der sich ein optimales Ätzprofil ausbildet.

Die Erfindung wird anhand der Figuren in der nachfolgenden Beschreibung beispielhaft näher erläutert. Von den Figuren zeigen:

Figur 1 eine schematische Darstellung eines Ausführungsbeispiels der erfindungsgemäßen Vorrichtung, und

Figur 2 den zeitlichen Verlauf der kapazitiv an die andere Elektrode der Vorrichtung nach Figur 1 gekoppelten, rechteckförmigen niederfrequenten Spannung und im Vergleich dazu den zeitlichen Verlauf einer Aufladung eines auf der anderen Elektrode aufgebrachten Substrats.

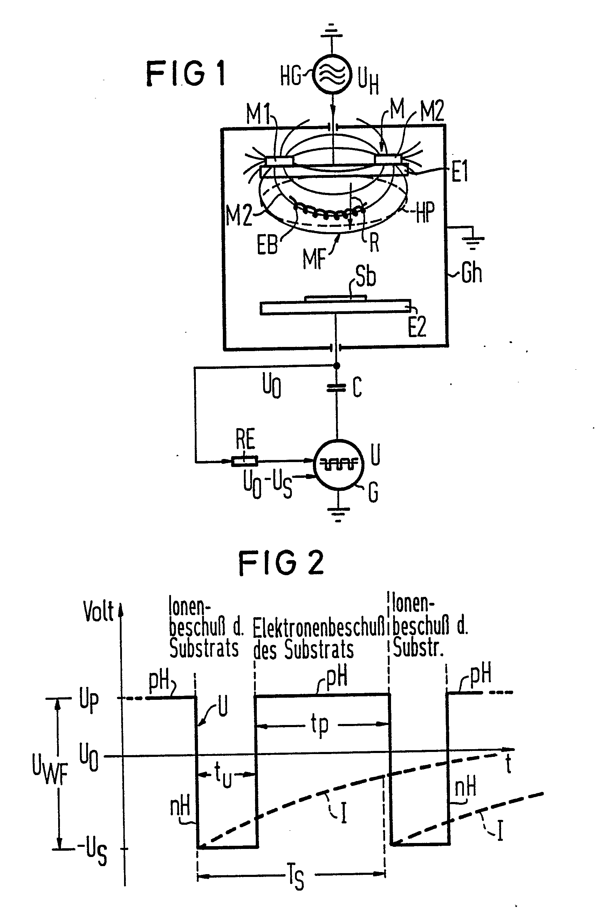

In der Figur 1 bezeichnen Gh ein mit Prozeßgas gefülltes oder durchsetztes Gehäuse E1 und E2 zwei im Gehäuse Gh und im Abstand zueinander angeordnete Elektroden, HG einen Hochfrequenzgenerator zur Erzeugung einer an die obere eine Elektrode E1 anzulegenden Hochfrequenzspannung $U_H$ zwecks Erzeugung eines Hochfrequenzplasmas HP zwischen den beiden Elektroden E1 und E2, G den Generator zur Erzeugung der niederfrequenten Spannung U, die über eine Kapazität C an die untere andere Elektrode E2 anzulegen ist, Sb ein auf dieser anderen Elektrode E2 angeordnetes zu ätzendes Substrat und M die Einrichtung zur Erzeugung des Magnetfeldes MF mit in Richtung R von der einen Elektrode E1 zur anderen Elektrode E2 abnehmender Feldstärke und quer zu dieser Richtung R verlaufenden Feldlinien ML. Die Niederfrequenz beträgt beispielsweise 50 KHz bis zu einigen 100 KHz, beispielsweise 50 kHz, während die Hochfrequenz im Megaherzbereich liegt, beispielsweise bei 13,56 MHz.

Aufgrund des vorstehend definierten Magnetfeldes MF wird das Hochfrequenzplasma nahe bei der einen Elektrode E1 konzentriert. Um die Feldlinien ML des Magnetfeldes MF spiralen sich die Elektronen - eine entsprechende Spiralbahn ist in der Figur 1 angedeutet und mit EB bezeichnet - und bewirken nur in diesem Bereich Ionisation. Damit erhöht sich noch einmal die Ionendichte und der Beschuß des Substrats mit Elektronen wird verringert. Ein Gitter ist nicht erforderlich.

Die Einrichtung M zur Erzeugung des Magnetfeldes MF besteht im Ausführungsbeispiel nach Figur 1 aus zwei im Abstand zueinander angeordneten Permanentmagnetstäben M1 und M2, die auf der einen Elektrode E1 angeordnet sind.

Der Generator G erzeugt eine rechteckwellenförmige niederfrequente Spannung U, deren zeitlicher Verlauf in dem in Figur 2 gezeigten Diagramm dargestellt ist, in welchem auf der Abszisse die Zeit t und auf der Ordinate Volt aufgetragen sind.

Die Spannung U ist einem mittleren Gleichgewichtspotential $U_O$ überlagert, das sich an dem Substrat Sb und damit an der anderen Elektrode E2 ausbildet. Die Gesamtamplitude der niederfrequenten Spannung U ist mit $U_{NF}$ bezeichnet.

Die Spannung U weist in Bezug auf das Gleichgewichtspotential $U_O$ eine negative Halbwelle nH mit einer Amplitude $U_O - U_S$ und eine positive Halbwelle pH mit einer Amplitude von $U_p - U_O$ auf.

Die Kurve I stellt den zeitlichen Verlauf der Aufladung des Substrats Sb nach einem Potentialsprung vom mittleren Gleichgewichtspotential $U_O$ nach $- U_S$ dar. Die Kurve I stellt eine Exponentialfunktion dar, gemäß der sich nach dem Potentialsprung mit zunehmender Zeit t das Potential des Substrats Sb einem neuen, höheren Gleichgewichtspotential annähern würde. Die Zeitkonstante dieser Exponentialfunktion I ist in der Figur 2 qualitativ eingetragen und mit $T_S$ bezeichnet.

Die Dauer $t_n$ der negativen Halbwelle nH, während welcher das Substrat Sb mit Ionen beschossen wird, ist kürzer als diese Zeitkonstante $T_S$ bemessen. Die Aufladung des Substrats Sb durch Ionenbeschuß erfolgt nur während dieser kurzen Dauer $t_n$ und ist relativ gering. Die während der Dauer $t_n$ konstante Amplitude $U_O - U_S$, die als Saugspannung wirksam ist, ändert sich während dieser Dauer $t_n$ nur wenig, so daß in dieser Zeit ein schmales Spektrum von Energien für die Ionen gegeben ist. Die Dauer $t_p$ oder/und die Amplitude $U_p$ $U_O$ der positiven Halbwelle pH ist so bemessen, daß der Elektronenbeschuß des Substrats Sb während der Dauer $t_p$ die geringfügige Aufladung des Substrats Sb rückgängig oder mehr als rückgängig macht, so daß das Substrat Sb im Mittel ladungsfrei oder negativ geladen bleibt. Vorzugsweise wird die positive Halbwelle pH so bemessen, daß das Substrat Sb ladungsfrei bleibt, weil dann $U_O = 0$

Volt ist und die Ionenenergie allein von $U_S$ abhängt. Wählt man einen Generator G, bei dem diese Amplitude steuerbar ist, so läßt sich die Ionenenergie allein durch diese Amplitude steuern.

Ein mittleres Gleichgewichtspotential des Substrats von 0 Volt läßt sich durch eine Regeleinrichtung aufrechterhalten, welche das mittlere Gleichgewichtspotential $U_0$ der anderen Elektrode E2 abtastet und durch Einstellen der Dauer $t_p$ oder/und der Amplitude $U_p$ auf 0 Volt regelt.

## Ansprüche

1. Vorrichtung zum reaktiven Ionenätzen, mit zwei im Abstand zueinander angeordneten Elektroden (E1, E2), zwischen denen durch Anlegen einer Hochfrequenzspannung ($U_H$) an eine Elektrode (E1) ein Hochfrequenzplasma (HP) erzeugbar ist, wobei an die andere Elektrode (E2), auf der ein zu ätzendes Substrat (Sb) anzuordnen ist, durch kapazitive Kopplung (C) eine niederfrequente Spannung (U) mit einer negativen Halbwelle anlegbar ist, **gekennzeichnet durch** einen Generator (G) zur Erzeugung einer niederfrequenten Spannung (U) mit einer negativen Halbwelle (nH), die eine im Vergleich zu einer Zeitkonstanten ($T_S$) für eine elektrische Aufladung des Substrats (Sb) kürzere Dauer ($t_n$) hat und mit einer derart bemessenen positiven Halbwelle (pH), deren Dauer ($t_p$) und/oder Amplitude ($U_p-U_o$) derart bemessen ist, daß das Substrat (Sb) im Mittel ladungsfrei oder negativ geladen bleibt.

2. Vorrichtung nach Anspruch 1, **dadurch gekennzeichnet,** daß die vom Generator (G) erzeugte Spannung (U) rechteckwellenförmig ist.

3. Vorrichtung nach Anspruch 1 oder 2, **gekennzeichnetdurch** eine Regeleinrichtung (RE), welche ein durch die vom Generator (G) erzeugte niederfrequente Spannung (U) erzeugtes mittleres Gleichgewichtspotential ($U_o$) der anderen Elektrode (E2) abtastet und durch Einstellen der negativen und positiven Halbwelle (nH, pH) der vom in Bezug auf diese Wellen (nH, pH) steuerbaren Generators (G) erzeugten niederfrequenten Spannung (U) auf ein vorbestimmtes Sollpotential regelt.

4. Vorrichtung nach Anspruch 3, **dadurch gekennzeichnet,** daß das Sollpotential Massepotential (0 V) ist.

5. Vorrichtung nach einem der vorhergehenden Ansprüche, insbesondere nach Anspruch 4, **dadurch gekenn zeichnet,** daß die Amplitude ($U_o-U_s$) der negativen Halbwelle (nH) steuerbar ist.

6. Vorrichtung zum reaktiven Ionenätzen, mit zwei im Abstand zueinander angeordneten Elektroden (E1, E2), zwischen denen durch Anlegen einer Hochfrequenzspannung ($U_H$) an eine Elektrode ein Hochfrequenzplasma (HP) erzeugbar ist, wobei auf der anderen Elektrode ein zu ätzendes Substrat (Sb) anzuordnen ist, insbesondere Vorrichtung nach einem der vorhergehenden Ansprüche, **gekennzeichnet durch** eine Einrichtung (M) zur Erzeugung eines Magnetfeldes (MF) im Bereich zwischen den beiden Elektroden (E1, E2), dessen Feldstärke von der einen Elektrode (E1) in Richtung zur anderen Elektrode (E2) abnimmt und dessen Feldlinien quer zur Richtung (R) verlaufen.

7. Vorrichtung nach Anspruch 5 oder 6, **dadurch gekennzeichnet,** daß die Einrichtung (M) zur Erzeugung des Magnetfeldes (MF) aus zwei im Abstand zueinander angeordneten Permanentmagnetstäben (M1, M2) besteht, die auf der einen Elektrode (E1) angeordnet sind.

# FIG 1

# FIG 2